Europäisches Patentamt

European Patent Office

Office européen des brevets

(19)

(11) Publication number: **0 117 723**
A2

(12) # EUROPEAN PATENT APPLICATION

(21) Application number: **84301171.9**

(22) Date of filing: **23.02.84**

(51) Int. Cl.³: **H 04 B 7/26**, H 04 H 3/00,
H 03 L 7/18

(30) Priority: **23.02.83 GB 8305037**

(43) Date of publication of application: **05.09.84**
Bulletin 84/36

(84) Designated Contracting States: **CH DE FR LI NL SE**

(71) Applicant: **McMICHAEL LIMITED, Sefton Park Bells Hill, Stoke Poges Slough Berkshire, SL2 4HB (GB)**

(72) Inventor: **O'Neill, Simon Philip, 21 Derwent Drive, Maidenhead Berkshire, SL6 6LE (GB)**

(74) Representative: **Dolwin, John Davison, Central Patent Department The General Electric Company plc Hirst Research Centre East Lane, Wembley Middlesex HA9 7PP (GB)**

(54) **Radio communications systems.**

(57) In a radio communication system having two or more fixed transmitter stations transmitting signals on nominally the same carrier frequency to mobile receivers which may be in a position to receive signals from both or all said transmitters, the actual carrier frequencies are arranged to be offset from one another by one, two or three Hertz in oder to avoid stationary «dead» zones.

-2-

The present invention relates to radio communications systems.

In particular the invention is concerned with radio communications systems of the kind in which signals at nominally the same carrier frequency may be transmitted simultaneously from two or more transmitter stations.

According to one aspect of the present invention a transmitter circuit arrangement, for use in a transmitter station of a radio communications system in which signals at nominally the same carrier frequency may be transmitted simultaneously from two or more transmitter stations of the system, comprises a phase-lock loop arrangement including a phase comparator for controlling the frequency of operation of a carrier frequency oscillator in said transmitter circuit arrangement in dependence upon the frequency of a reference signal applied to said phase comparator, and single sideband mixer means connected in said phase-lock loop between said oscillator and said phase comparator and arranged selectively to offset the frequency of a signal derived from said oscillator.

According to another aspect of the present invention in a radio communications system in which signals at nominally the same carrier frequency which may be transmitted from two or more transmitter stations of the system are arranged to be offset from one another in frequency by the order of one or a few Hertz, and in which the carrier frequency in respect of each of said stations is controlled in dependence upon the frequency of a standard frequency reference signal by means of a phase-locked loop arrangement, the frequency off-set of one or a few Hertz at any one transmitter station of the system is introduced by means of a single side-band mixer arrangement included in the phase-locked loop arrangement at that station.

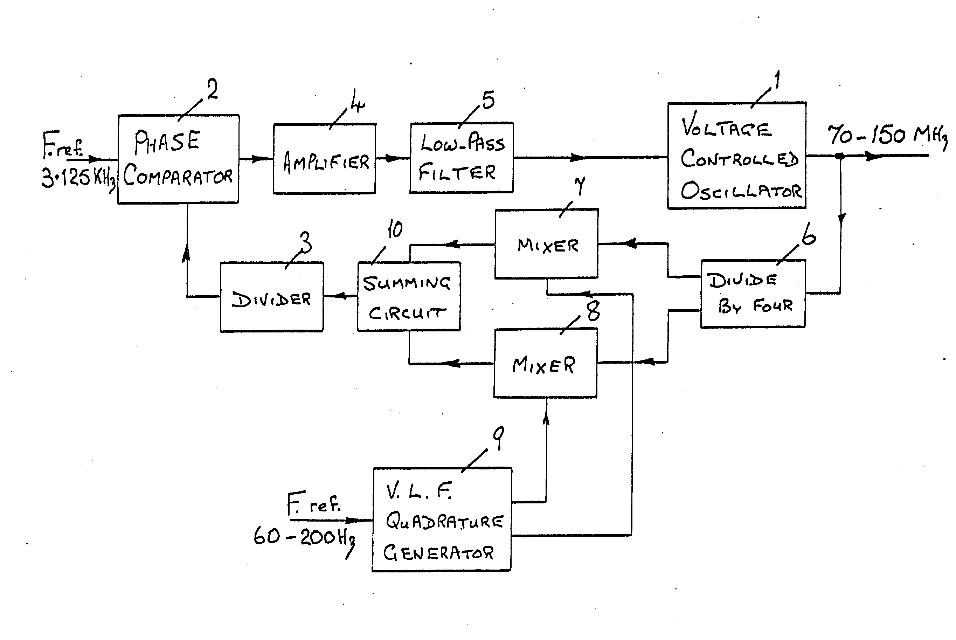

A transmitter arrangement for a radio communications system in accordance with the present invention will now be described by way of example with reference to the accompanying drawing, which shows part of the transmitter arrangement schematically.

In radio communications systems in which carrier signals at nominally the same frequency may be transmitted simultaneously from two or more fixed stations to cover an area within which a mobile receiver apparatus may be located, the carrier signals being modulated in common with voice-message signals intended for the mobile receiver apparatus, the precise carrier frequencies transmitted by the two or more fixed stations have to be carefully controlled to avoid deleterious interference at the mobile receiver apparatus. For example if the carrier signal frequencies are identical there will be within the area covered by the fixed stations certain "dead" zones in which signals from different fixed stations will largely cancel each other so that a mobile unit finding itself within one of these zones will fail to receive voice message signals intended for it. On the other hand if the carrier signal frequencies from two stations differ by more than a few cycles per second, up to the upper end of the voice signal frequency range the combined signals received by a mobile unit from two or more fixed stations will vary in amplitude at the beat frequency, with a corresponding effect on the quality of the voice message signals when demodulated.

To avoid the above defects the carrier signals transmitted by any two or more fixed stations whose effective areas overlap are controlled to a precise frequency plus or minus one, two or three cycles per second, such that there are no stationary dead zones

-4-

and the beat frequency at any mobile unit receiving two or more carrier signals is virtually undetectable in the voice message signals when demodulated. The precise frequency may be derived at each fixed station from a standard source, such as a rubidium frequency source, which source is used to control the frequency of the carrier frequency oscillator at the respective station by way of a phase-locked loop, and the frequency off-set assigned for any one station may be introduced into the phase-locked loop.

Referring now to the drawing the output frequency of a carrier-frequency oscillator 1, which frequency may be in the range 70 to 150 MHz, is phase-locked to a reference frequency of 3.125 KHz which is derived from a standard 1 MHz output rubidium source (not shown) and which is applied to a phase comparator 2. An output signal from the oscillator 1 is applied to the phase comparator 2 by way of a frequency divider 3, and a voltage control signal for the oscillator 1 is derived from the output of the phase comparator 2 by way of an amplifier 4 and a low pass filter 5.

Included in the phase-locked loop is a single side-band mixer arrangement comprising a divide-by-four circuit 6 which provides quadrature inputs at one quarter of the carrier frequency to respective mixers 7 and 8 to which are also applied quadrature input signals at 1/4 Hz, $\frac{1}{2}$ Hz or 3/4 Hz from a very low frequency generator 9. The output signals from the mixers 7 and 8 are added in a summing circuit 10 before application to the frequency divider 3.

The effect of the signals introduced by the single side-band mixer arrangement is to offset the carrier frequency generated by the oscillator 1 by 1, 2 or 3 Hz.

In order to avoid unwanted mixing products or harmonics being introduced into the phase-locked loop the inputs to the mixers 7 and 8 need to be accurately in quadrature. This is ensured by the divide-by-four circuits 6 in the case of the signals derived from the output of the oscillator 1. The very low frequency generator 9 comprises storage means, such as a read-only memory, for amplitude-coded values representing sine and cosine waveforms which are read out in succession under the control of, say, 60-200 Hz clock signals to provide the required quadrature signals at 1/4, 1/2 or 3/4 Hz. Since these signals are made up of varying amplitude steps occurring at the clock rate of 60-200 Hz any harmonics introduced by this means of generation are very widely separated from the required quadrature signals and thus easily filtered out. A filter (not shown) may be included for this purpose between the summing circuit 10 and the divider 3.

The divide-by-four circuit 6 may be replaced by an analogue phase shifter arrangement, for example for higher frequency operation. In this case the very low frequency signals would be at 1, 2 or 3 Hz and the reference frequency would be 12.5 KHz.

0117723

CLAIMS

1.    A transmitter circuit arrangement for use in a transmitter station of a radio communications system in which signals at nominally the same carrier frequency may be transmitted simultaneously from two or more transmitter stations of the system, comprising a phase-lock loop arrangement including a phase comparator for controlling the frequency of operation of a carrier frequency oscillator in said transmitter circuit arrangement in dependence upon the frequency of a reference signal applied to said phase comparator, and single sideband mixer means connected in said phase-lock loop between said oscillator and said phase comparator and arranged selectively to offset the frequency of a signal derived from said oscillator.

2.    A radio communication system in which signals at nominally the same carrier frequency which may be transmitted from two or more transmitter stations of the system are arranged to be offset from one another in frequency by the order of one or a few Hertz, and in which the carrier frequency in respect of each of said stations is controlled in dependence upon the frequency of a standard frequency reference signal by means of a phase-locked loop arrangement, wherein the frequency off-set of one or a few Hertz at any one transmitter station of the system is introduced by means of a single side-band mixer arrangement included in the phase-locked loop arrangement at that station.

3.    A radio communication system in accordance with Claim 2 wherein said single side-band mixer arrangement comprises quadrature mixers and a summing circuit in said phase-locked loop.

4.    A radio communication system in accordance with Claim 3 wherein frequency off-set signals are derived from amplitude-coded values read out in succession from a read-only memory to provide substantially sine and cosine waveforms for said quadrature mixers.

5.    A radio communication system in accordance with Claim 3 or Claim 4 wherein the carrier frequency is

-7-

applied to a divide-by-four circuit to provide quadrature signals for said quadrature mixers.